(19) Europäisches Patentamt
European Patent Office
Office européen des brevets

(11) EP 2 457 970 A1

(12) EUROPEAN PATENT APPLICATION

(43) Date of publication:
30.05.2012 Bulletin 2012/22

(51) Int Cl.:
*C09J 7/02* (2006.01)

(21) Application number: 11009369.7

(22) Date of filing: 25.11.2011

(84) Designated Contracting States:
AL AT BE BG CH CY CZ DE DK EE ES FI FR GB GR HR HU IE IS IT LI LT LU LV MC MK MT NL NO PL PT RO RS SE SI SK SM TR
Designated Extension States:
BA ME

(30) Priority: 30.11.2010 JP 2010266029
11.10.2011 JP 2011223826

(71) Applicant: Nitto Denko Corporation
Ibaraki-shi,
Osaka 567-8680 (JP)

(72) Inventors:
• Yoshida, Mariko
Osaka 567-8680 (JP)
• Yamato, Jiro
Osaka 567-8680 (JP)
• Sawazaki, Ryohei
Osaka 567-8680 (JP)
• Hayashi, Keiji
Osaka 567-8680 (JP)

(74) Representative: Müller-Boré & Partner
Patentanwälte
Grafinger Straße 2
81671 München (DE)

(54) **Surface protective sheet**

(57) Provided is a surface protective sheet which satisfactorily adheres even to a coated surface having a rough surface, and not only does not cause an adhesive residue that can be observed with eyes but also does not impair the self-cleaning property of the surface of a coated plate. The surface protective sheet includes: a base material layer; and a pressure-sensitive adhesive layer, in which: a main component in a pressure-sensitive adhesive for constructing the pressure-sensitive adhesive layer includes a polymer P obtained by cross-linking a polymer A; in pulse NMR measurement of the polymer P at 30°C, the maximum spin-spin relaxation time $T2_{MAX}$ in all spin-spin relaxation times T2 of protons to be measured falls within the range of 300 to 800 $\mu$s; and the content of a polymer component corresponding to the maximum spin-spin relaxation time $T2_{MAX}$ in the polymer P is 60% or more.

FIG. 1

**Description**

The present invention relates to a surface protective sheet. The surface protective sheet of the present invention is used in, for example, an application where the surface of a member such as a metal plate, a coated plate, an aluminum sash, a resin plate, a decorated steel plate, a vinyl chloride-laminated steel plate, or a glass plate, an optical member such as a polarizing sheet or a liquid crystal panel, an electronic member, or the like is protected by attaching the sheet to the surface of any such member during, for example, conveyance, processing, or guarding of the member. The surface protective sheet is particularly useful as a surface protective sheet, whose degree of contamination is requested to be low, for a hydrophilic member obtained by hydrophilizing the surface of a metal plate, a resin plate, a glass plate, or the like with a hydrophilic coating film or a surface treatment, a substrate with an antireflection function formed so as to have a thickness corresponding to a quarter of a wavelength to be prevented from reflecting, a substrate with an antireflection function based on a nano-level uneven structure, or the like.

There exist various coated plates such as a coated steel plate ranging from a plate having a smooth surface to a plate having a rough surface, and the attachment of a surface protective sheet to the surface of any such plate has been generally performed for protecting the surface from, for example, a flaw at the time of its conveyance or processing. The surface protective sheet is typically obtained by providing one side of a base material layer with a pressure-sensitive adhesive layer.

A surfaceprotective sheet whose adhesion is excellently prevented from increasing with days has been reported as the surface protective sheet (Japanese Patent Application Laid-open No. 2010-42580). However, the surface protective sheet described in Japanese Patent Application Laid-open No. 2010-42580 involves the following problem. Its pressure-sensitive adhesive is so hard that the sheet is not bonded to a coated plate having a rough surface.

In view of the foregoing, a surface protective sheet which is excellent in pressure-sensitive adhesiveness for a rough surface and is excellentlyprevented from causing an adhesive residue has been reported (Japanese Patent Application Laid-open No. 2007-270022, Japanese Patent Application Laid-openNo. 2001-106995, and Japanese Patent Application Laid-open No. 2010-106231). When the surface protective sheet described in Japanese Patent Application Laid-open No. 2007-270022, Japanese Patent Application Laid-open No. 2001-106995, or Japanese Patent Application Laid-open No. 2010-106231 is used for a general-purpose coated plate, the sheet is excellent in pressure-sensitive adhesiveness for a rough surface and no adhesive residue is observed with eyes. Accordingly, the sheet causes no serious problem in practical use.

A hydrophilic coated plate to which a hydrophilic fine particle or a hydrophilic polymer is added has started to become widespread as a new coated plate that replaces a conventional coated plate in recent years. Such hydrophilic coated plate has self-cleaning property and has such a function that even when its surface receives dirt, the dirt can be removed with rainwater or the like. When the surface protective sheet described in Japanese Patent Application Laid-open No. 2007-270022, Japanese Patent Application Laid-open No. 2001-106995, or Japanese Patent Application Laid-open No. 2010-106231 is used for such hydrophilic coated plate, the sheet shows good pressure-sensitive adhesiveness and no adhesive residue is observed with eyes. However, a pressure-sensitive adhesive residue that cannot be observed with the eyes exists on the surface of the hydrophilic coated plate, and as a result, such a problem that the self-cleaning property of the hydrophilic coated plate after the release of the surface protective sheet disappears arises.

The present invention has been made to solve the above-mentioned conventional problems, and an object of the present invention is to provide a surface protective sheet which satisfactorily adheres even to a coated surface having a rough surface, and not only does not cause an adhesive residue that can be observed with eyes but also does not impair the self-cleaning property of the surface of a coated plate.

A surface protective sheet of the present invention includes: a base material layer; and a pressure-sensitive adhesive layer, in which: a main component in a pressure-sensitive adhesive for constructing the pressure-sensitive adhesive layer includes a polymer P obtained by cross-linking a polymer A; in pulse NMR measurement of the polymer P at 30°C, the maximum spin-spin relaxation time $T2_{MAX}$ in all spin-spin relaxation times T2 of protons to be measured falls within the range of 300 to 800 $\mu$s; and the content of a polymer component corresponding to the maximum spin-spin relaxation time $T2_{MAX}$ in the polymer P is 60% or more.

In a preferred embodiment, when a content of a polymer component corresponding to each of the above-mentioned spin-spin relaxation times T2 in the polymer P is represented by AM, $\Sigma T2AM$ is 300 $\mu$s or more.

In a preferred embodiment, an insoluble content of the above-mentioned polymer P in ethyl acetate is 98 wt% or more.

In a preferred embodiment, the above-mentioned polymer A includes an acrylic polymer obtained by polymerizing a monomer composition containing a (meth) acrylate monomer as a main component.

In a preferred embodiment, the above-mentioned polymer A has a weight-average molecular weight Mw of 500, 000 to 1, 500, 000.

In a preferred embodiment, the above-mentioned polymer A has a molecular weight distribution Mw/Mn of 8.0 or less.

In a preferred embodiment, the pressure-sensitive adhesive layer has an adhesion for a coated steel plate having a ten-point average surface roughness Rz of 8.0 $\mu$m of 0.05 to 2.5 N/20 mm.

According to another aspect of the present invention, there is provided an article (goods). The article has the above-mentioned surface protective sheet releasably attached thereto.

According to still another aspect of the present invention, there is provided a method of using a surface protective sheet. The method of using a surface protective sheet includes releasably attaching the above-mentioned surface protective sheet to an adherend to protect the adherend.

According to the present invention, it is possible to provide the surface protective sheet which satisfactorily adheres even to a coated surface having a rough surface, and not only does not cause an adhesive residue that can be observed with eyes but also does not impair the self-cleaning property of the surface of a coated plate.

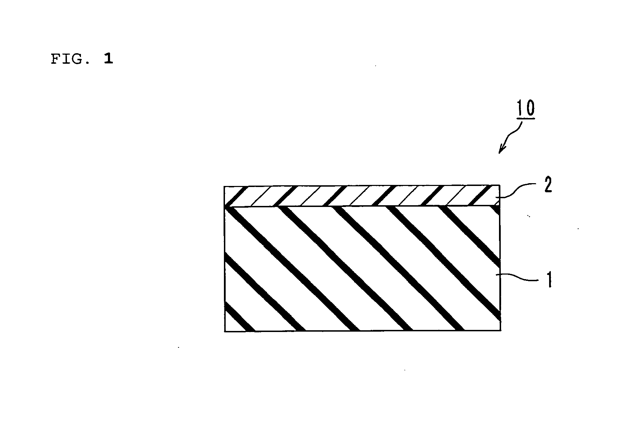

FIG. 1 is a schematic sectional view of a surface protective sheet according to a preferred embodiment of the present invention.

«A. Surface protective sheet»

A surface protective sheet of the present invention includes a base material layer and a pressure-sensitive adhesive layer. FIG. **1** is a schematic sectional viewof a surfaceprotective sheet according to a preferred embodiment of the present invention. A surface protective sheet **10** includes a base material layer **1** and a pressure-sensitive adhesive layer **2.** The surface protective sheet of the present invention may further have any appropriate other layer as required (not shown).

The surface of the base material layer **1** on which the pressure-sensitive adhesive layer **2** is not provided can be subj ected to a release treatment by adding, for example, a fatty acid amide, a polyethyleneimine, or a long-chain alkyl-based additive to the base material layer, or can be provided with a coat layer formed of any appropriate releasing agent such as a silicone-, long-chain alkyl-, or fluorine-based releasing agent for the purpose of, for example, forming a winding body that can be easily rewound. In addition, separately from the base material, a release liner having releasability may be attached.

The thickness of the surface protective sheet of the present invention can be set to any appropriate thickness depending on applications. The thickness is preferably 10 to 300 $\mu$m, more preferably 15 to 250 $\mu$m, still more preferably 20 to 200 $\mu$m, particularly preferably 25 to 150 $\mu$m from the viewpoints of, for example, the prevention of a flaw and an adhesion.

In the surfaceprotective sheet of the present invention, the pressure-sensitive adhesive layer has an adhesion for a coated steel plate having a ten-point average surface roughness Rz of 8.0 $\mu$m of preferably 0.05 to 2.5 N/20 mm, more preferably 0.10 to 1.5 N/20 mm, still more preferably 0.10 to 1.0 N/20 mm, particularly preferably 0.15 to 0.8 N/20 mm, most preferably 0.20 to 0.8 N/20 mm. Here, the "coated steel plate having a ten-point average surface roughness Rz of 8.0 $\mu$m" specifies an adherend as a reference upon evaluation of the pressure-sensitive adhesive layer in the surface protective sheet of the present invention for its adhesion. The "ten-point average surface roughness Rz" is a known indicator as an indicator of the roughness of a surface. The surface protective sheet of the present invention can express good pressure-sensitive adhesiveness even for a coated surface having a rough surface as long as the adhesion of the pressure-sensitive adhesive layer for the coated steel plate having a ten-point average surface roughness Rz of 8.0 $\mu$m falls within the above-mentioned range.

The surface protective sheet of the present invention can be used by being releasably attached to an adherend such as: a member such as a metal plate, a coated plate, an aluminum sash, a resin plate, a decorated steel plate, a vinyl chloride-laminated steel plate, or a glass plate; an optical member such as a polarizing sheet or a liquid crystal panel; or an electronic member.

<A-1. Base material layer>

Any appropriate thickness can be adopted as the thickness of the base material layer depending on applications. The thickness of the base material layer is preferably 5 to 300 $\mu$m, more preferably 10 to 250 $\mu$m, still more preferably 15 to 200 $\mu$m, particularly preferably 20 to 150 $\mu$m.

The base material layer may be a single layer, or may be a laminate of two or more layers. The base material layer may be stretched.

Any appropriate material can be adopted as a material for the base material layer depending on applications. Examples of the material include a plastic, paper, a metal film, and a nonwoven fabric. Of those, a plastic is preferred. The materials may be used alone or in combination to construct the base material layer. For example, the layer may be constructed of two or more kinds of plastics.

Examples of the above-mentioned plastic include a polyester-based resin, a polyamide-based resin, and a polyolefin-based resin. Examples of the polyester-based resin include polyethylene terephthalate, polybutylene terephthalate, and polyethylene naphthalate. Examples of the polyolefin-based resin include a homopolymer of an olefin monomer and a copolymer of olefinmonomers. Specific examples of the polyolefin-based resin include: homopolypropylene; propylene-based copolymers such as block, random, and graft copolymers each including an ethylene component as a copolymer component; reactor TPO; ethylene-based polymers such as low density, high density, linear low density, and ultra low density polymers; and ethylene-based copolymers such as an ethylene-propylene copolymer, an ethylene-vinyl acetate copolymer, an ethylene-methyl acrylate copolymer, an ethylene-ethyl acrylate copolymer, an ethylene-butyl acrylate copolymer, an ethylene-methacrylic acid copolymer, and an ethylene-methyl methacrylate copolymer.

The base material layer may contain any appropriate additive as required. Examples of the additive that can be contained in the base material layer include an antioxidant, a UV absorbing agent, a light stabilizer, an antistatic agent, a filler, and a pigment. The kind, number, and amount of the additive that can be contained in the base material layer can be appropriately set depending on purposes. In particular, when the material for the base material layer is a plastic, it is preferred to contain some of the above-mentioned additives for the purpose of, for example, preventing deterioration. From the viewpoint of, for example, the improvement of weather resistance, particularly preferred examples of the additive include an antioxidant, a UV absorbing agent, a light stabilizer, and a filler.

Any appropriate antioxidant can be adopted as the antioxidant. Examples of such antioxidant include a phenol-based antioxidant, a phosphorus-based processing heat stabilizer, a lactone-based processing heat stabilizer, a sulfur-based heat stabilizer, andaphenol-phosphorus-basedantioxidant. The content of the antioxidant is preferably 1 part by weight or less, more preferably 0.5 part by weight or less, still more preferably 0.01 to 0.2 part by weight with respect to 100 parts by weight of the base resin of the base material layer (when the base material layer is a blend, the blend is the base resin).

Any UV absorbing agent can be adopted as the UV absorbing agent. Examples of such UV absorbing agent include a benzotriazole-based UV absorbing agent, a triazine-based UV absorbing agent, and a benzophenone-based UV absorbing agent. The content of the UV absorbing agent is preferably 2 parts by weight or less, more preferably 1 part by weight or less, still more preferably 0.01 to 0.5 part by weight with respect to 100 parts by weight of the base resin that forms the base material layer (when the base material layer is a blend, the blend is the base resin).

Any appropriate light stabilizer can be adopted as the light stabilizer. Examples of such light stabilizer include a hindered amine-based light stabilizer and a benzoate-based light stabilizer. The content of the light stabilizer is preferably 2 parts by weight or less, more preferably 1 part by weight or less, still more preferably 0.01 to 0.5 part by weight with respect to 100 parts by weight of the base resin that forms the base material layer (when the base material layer is a blend, the blend is the base resin).

Any appropriate filler can be adopted as the filler. Examples of such filler include an inorganic filler. Specific examples of the inorganic filler include carbon black, titanium oxide, and zinc oxide. The content of the filler is preferably 20 parts by weight or less, more preferably 10 parts by weight or less, still more preferably 0.01 to 10 parts by weight with respect to 100 parts by weight of the base resin that forms the base material layer (when the base material layer is a blend, the blend is the base resin).

Further, a surfactant, an inorganic salt, a polyhydric alcohol, a metal compound, an inorganic antistatic agent such as carbon, and low molecular-weight and high molecular-weight antistatic agents each intended to impart antistatic property are also preferably given as examples of the additive. Of those, a high-molecular weight antistatic agent or carbon is particularly preferred from the viewpoints of contamination and the maintenance of pressure-sensitive adhesiveness.

<A-2. Pressure-sensitive adhesive layer>

The thickness of the pressure-sensitive adhesive layer is preferably 1 to 100 $\mu$m, more preferably 2 to 50 $\mu$m, still more preferably 5 to 30 $\mu$m, particularly preferably 5 to 20 $\mu$m.

The pressure-sensitive adhesive layer is constructed of a pressure-sensitive adhesive. The pressure-sensitive adhesives may be used alone or in combination. Thepressure-sensitive adhesive preferably contains a polymer P obtained by cross-linking a polymer A as a main component. Specifically, the content of the polymer P in the pressure-sensitive adhesive is preferably 50 wt% or more, more preferably 80 wt% or more, still more preferably 90 wt% or more, particularly preferably 95 wt% or more.

The polymer A has a weight-average molecular weight Mw (in terms of a standard polystyrene) of preferably 500,000 to 1,500,000, more preferably 520,000 to 1,200,000, still more preferably 550,000 to 1,000,000. As long as the weight-average molecular weight Mw of the polymer A falls within the above-mentioned range, a surface protective sheet that does not impair the self-cleaning property of the surface of a coated plate can be provided.

The polymer A has a molecular weight distribution Mw/Mn of preferably 8.0 or less, more preferably 2.0 to 7.0, still more preferably 3.0 to 5.0. As long as the distribution degree Mw/Mn of the polymer A falls within the above-mentioned range, a surface protective sheet that does not impair the self-cleaning property of the surface of a coated plate can be provided.

In the pulse NMR measurement of the polymer P at 35°C, the maximum spin-spin relaxation time T2$_{MAX}$ in all the spin-spin relaxation times T2 of protons to be measured (which may hereinafter be simply referred to as "spin-spin relaxation times T2") falls within the range of 300 to 800 μs, preferably 400 to 600 μs, more preferably 450 to 550 μs. The spin-spin relaxation times T2 can each be an indication of the cross-link density of a polymer component for constructing the polymer P because the reciprocals of the spin-spin relaxation times and the cross-link densities (degrees of restraint of the molecular motions) of the polymer show a positive, linear correlation. Specifically, when the polymer P is subjected to the pulse NMR measurement, one or more (for example, two or three) spin-spin relaxation times T2 are obtained, and whether each spin-spin relaxation time T2 is short or long corresponds to whether the cross-link density of a polymer component for constructing the polymer P is high or low. That is, a polymer component having a high cross-link density whose molecular motion is restrained shows a short spin-spin relaxation time T2. On the other hand, a polymer component having a low cross-link density shows a long spin-spin relaxation time T2. In the present invention, the incorporation of such a polymer component that the maximum spin-spin relaxation time T2$_{MAX}$ falls within the above-mentioned range canprovide a surface protective sheet that satisfactorily adheres even to a coated surface having a rough surface and does not impair the self-cleaning property of the surface of a coated plate. The spin-spin relaxation times T2 (that is, the cross-link densities and cross-link density distribution of the polymer components) of the polymer P can be controlled by adjusting, for example, the kind and content of a cross-linking agent (to be described later) at the time of cross-linking for obtaining the polymer P. It should be noted that the spin-spin relaxation times T2 in the specification are measured by a solid-echo method (90°x-τ-90°y).

The content of the polymer component corresponding to the maximum spin-spin relaxation time T2$_{MAX}$ in the polymer P is 60% or more, preferably 63 to 90%, more preferably 68 to 85%. As long as the content falls within such range, a surface protective sheet that satisfactorily adheres even to a coated surface having a rough surface and does not impair the self-cleaning property of the surface of a coated plate can be provided. It should be noted that the content of the polymer component corresponding to the maximum spin-spin relaxation time T2$_{MAX}$ in the polymer P is determined by: subjecting a free induction decay (FID) curve obtained by the pulse NMR measurement to linear square method analysis; specifying a range to be calculated from a component having a long relaxation time after the analysis; and subjecting the range to recalculation by a nonlinear least square method.

When the content of a polymer component corresponding to each spin-spin relaxation time T2 in the polymer P is represented by AM(%), ΣT2AM (that is, the weighted average of the spin-spin relaxation times T2 with the content of each polymer component as a weight) is preferably 300 μs or more, more preferably 350 μs or more, still more preferably 400 μs or more, particularly preferably 400 to 550 μs. As long as the ΣT2AM falls within such range, a surface protective sheet that does not impair the self-cleaning property of the surface of a coated plate can be provided.

The insoluble content of the polymer P in ethyl acetate is preferably 98 wt% or more, more preferably 99 wt% or more. As long as the insoluble content of the polymer P in ethyl acetate falls within the above-mentioned range, a surface protective sheet that does not impair the self-cleaning property of the surface of a coated plate can be provided.

The pressure-sensitive adhesive for constructing the pressure-sensitive adhesive layer is preferably an acrylic pressure-sensitive adhesive.

The polymer A before the cross-linking for obtaining the polymer P as a main component in the acrylic pressure-sensitive adhesive is preferably an acrylic polymer obtained by polymerizing a monomer composition containing a (meth) acrylate monomer as a main component. The adoption of such acrylic polymer as the polymer A can provide a surface protective sheet that does not impair the self-cleaning property of the surface of a coated plate. It should be noted that the expression "(meth)acrylate" means at least one of an acrylate and a methacrylate.

The content of the (meth) acrylate monomer in the monomer composition is preferably 50 wt% or more, more preferably 60 to 99 wt%, still more preferably 70 to 98 wt%, particularly preferably 80 to 97 wt%. As long as the content of the (meth) acrylate monomer in the monomer composition falls within the above-mentioned range, a surface protective sheet which satisfactorily adheres even to a coated surface having a rough surface, and not only does not cause an adhesive residue that can be observed with eyes but also does not impair the self-cleaning property of the surface of a coated plate can be provided.

Examples of the (meth) acrylate monomer include methyl (meth) acrylate, ethyl (meth) acrylate, n-butyl (meth) acrylate, s-butyl (meth)acrylate, t-butyl (meth)acrylate, isobutyl (meth)acrylate, hexyl (meth)acrylate, 2-ethylhexyl (meth) acrylate, n-octyl (meth)acrylate, isooctyl (meth)acrylate, n-nonyl (meth)acrylate, isononyl (meth)acrylate, n-decyl (meth) acrylate, isodecyl (meth)acrylate, n-dodecyl (meth)acrylate, n-tridecyl (meth)acrylate, and n-tetradecyl (meth)acrylate.

The (meth)acrylate monomers may be used alone or in combination in the monomer composition.

It is preferred that the monomer composition include a functional group-containing monomer for cross-linking. Examples of such functional group-containing monomer include a carboxyl group-containing monomer, an acid anhydride group-containing monomer, a hydroxyl group-containing monomer, an amino group-containing monomer, an epoxy group-containing monomer, an isocyanate group-containing monomer, and an aziridine group-containing monomer. Specific examples of such functional group-containing monomer include (meth)acrylic acid, 2-hydroxyethyl (meth)acrylate, 2-hydroxypropyl (meth)acrylate, 4-hydroxybutyl (meth)acrylate, 6-hydroxyhexyl (meth)acrylate, 8-hydroxyoctyl (meth)acrylate, 10-hydroxydecyl (meth)acrylate, 12-hydroxylauryl (meth)acrylate, (4-hydroxymethylcyclohexyl)methyl acrylate, N-methylol (meth)acrylamide, vinyl alcohol, allyl alcohol, 2-hydroxyethyl vinyl ether, 4-hydroxybutyl vinyl ether, diethylene glycol monovinyl ether, glycidyl (meth) acrylate, methylglycidyl (meth)acrylate, and allyl glycidyl ether. It should be noted that the expression "(meth)acrylic acid" means at least one of acrylic acid and methacrylic acid, and the expression " (meth) acrylate" means at least one of an acrylate and a methacrylate.

The functional group-containing monomers may be used alone or in combination in the monomer composition.

The content of the functional group-containing monomer in the monomer composition is preferably 1 to 25 wt%, more preferably 1 to 20 wt%, still more preferably 2 to 15 wt%, particularly preferably 3 to 10 wt%. As long as the content of the functional group-containing monomer in the monomer composition falls within the above-mentioned range, a surface protective sheet which satisfactorily adheres even to a coated surface having a rough surface, and not only does not cause an adhesive residue that can be observed with eyes but also does not impair the self-cleaning property of the surface of a coated plate can be provided.

The monomer composition may include, as a monomer for controlling releasability, a sulfonic acid group-containing monomer, aphosphoricacidgroup-containingmonomer, acyanogroup-containing monomer, a vinyl ester monomer, an aromatic vinyl monomer, an amide group-containing monomer, an imide group-containing monomer, N-acryloylmorpholine, a vinyl ether monomer, or the like. Specific examples of such monomer include styrene, chlorostyrene, chloromethylstyrene, α-methylstyrene, vinyl acetate, and acrylonitrile. The above-mentioned monomers in the monomer composition may be used alone or in combination.

The acrylic pressure-sensitive adhesive capable of constructing the pressure-sensitive adhesive layer has a glass transition temperature (Tg) in the FOX equation of preferably -80 to 0˚C, more preferably -70 to -10˚C, still more preferably -60 to -20˚C. As long as the glass transition temperature (Tg) falls within the above-mentioned range, a surface protective sheet that can satisfactorily adhere even to a coated surface having a rough surface can be provided. It should be noted that the glass transition temperature (Tg) can be adjusted by appropriately changing monomer components to be used and their composition ratio.

The polymer P is obtained by cross-linking the polymer A. That is, examples of the polymer P include a cross-linked polymer obtained by causing the polymer A and any appropriate cross-linking agent to react with each other, and a cross-linked polymer obtained by irradiating the polymer A with an active energy ray (such as ultraviolet light or an electron beam) to subject the polymer to a cross-linking reaction.

Any appropriate cross-linking agent can be adopted as a cross-linking agent that can be used for cross-linking the polymer A to provide the polymer P. Examples of such cross-linking agent include an epoxy-based cross-linking agent, a polyfunctional isocyanate-based cross-linking agent, a melamine resin-based cross-linking agent, a metalsalt-based cross-linking agent, a metal chelate-based cross-linking agent, an amino resin-based cross-linking agent, and a peroxide-based cross-linking agent. It should be noted that a cross-linked structure can be constructed by the application of an active energy ray such as ultraviolet light or an electron beam as well irrespective of whether the cross-linking agent is used. The cross-linking agents may be used alone or in combination.

The usage of the cross-linking agent is preferably 20 parts by weight or less, more preferably 10 parts by weight or less, still more preferably 1 to 8 parts by weight with respect to 100 parts by weight of the polymer Abefore the cross-linking for obtaining the polymer P as the main component of the pressure-sensitive adhesive. When the content of the cross-linking agent deviates from the above-mentioned range, the cross-linking agent itself may be responsible for contamination.

Examples of the cross-linking agent to be particularly preferably used include an epoxy-based cross-linking agent and a polyfunctional isocyanate-based cross-linking agent.

A polyfunctional epoxy compound is preferably used as the epoxy-based cross-linking agent, and includes various compounds each having two or more epoxy groups in the molecule. Representative examples thereof include sorbitol tetraglycidyl ether, trimethylolpropane glycidyl ether, tetraglycidyl-1,3-bisaminomethylcyclohexane, tetraglycidyl-m-xyl-enediamine, and triglycidyl-p-aminophenol.

A polyfunctional isocyanate compound is preferably used as the isocyanate-based cross-linking agent, and includes various compounds each including two or more isocyanate groups in the molecule. Representative examples thereof include diphenylmethane diisocyanate, tolylene diisocyanate, and hexamethylene diisocyanate.

Any appropriate additive can be contained in the pressure-sensitive adhesive for constructing the pressure-sensitive adhesive layer. Examples of such additive include a softener, a tackifier, a surface lubricating agent, a leveling agent, an antioxidant, a corrosion inhibitor, a light stabilizer, a UV absorbing agent, aheat stabilizer, apolymerization inhibitor, a silane coupling agent, a lubricant, an inorganic or organic filler, a metal powder, a pigment, and a solvent.

The tackifier is effective in improving an adhesion, in particular, improving pressure-sensitive adhesiveness for an adherend having a rough surface. Any appropriate tackifier can be adopted as the tackifier. Examples of such tackifier include petroleum-based resins such as an aliphatic copolymer, an aromatic copolymer, an aliphatic-aromatic copolymer system, and an alicyclic copolymer, a coumarone-indene-based resin, a terpene-based resin, a terpene phenol-based resin, a rosin-based resin such as a polymerized rosin, an (alkyl) phenol-based resin, a xylene-based resin, and hydrogenated products thereof. The tackifiers may be used alone or in combination.

The content of the tackifier is preferably 50 parts by weight or less, more preferably 30 parts by weight or less, still more preferably 10 parts by weight or less with respect to 100 parts by weight of the polymer P as the main component of the pressure-sensitive adhesive. When the content of the tackifier deviates from the above-mentioned range, pressure-sensitive adhesiveness at low temperatures may be poor or an adhesive residue at high temperatures may be remarkable.

The pressure-sensitive adhesive for constructing the pressure-sensitive adhesive layer can be produced by any appropriate method. The pressure-sensitive adhesive for constructing the pressure-sensitive adhesive layer can be produced, for example, as described below. While a polymerization method to be generally employed as an approach to synthesizing a polymer, such as solution polymerization, emulsion polymerization, bulk polymerization, suspension polymerization, orpolymerization with ultraviolet light (UV) is employed, any appropriate cross-linking method is adopted, and any appropriate additive is used as required.

Of the polymerization methods, solution polymerization, emulsion polymerization, suspension polymerization, or polymerization with ultraviolet light (UV) is preferred because a pressure-sensitive adhesive having a high molecular weight and a low distribution degree can be produced. With regard to, for example, the solution polymerization, a polymerization initiator and a solvent are added to the monomer composition, and any appropriate additive is added to the mixture as required so that the solution polymerization may be performed.

Any appropriate polymerization initiator can be adopted as the polymerization initiator. Examples of such polymerization initiator include an azo-based compound and a peroxide. Specific examples of such polymerization initiator include 2,2'-azobisisobutyronitrile, 2,2'-azobisisovaleronitrile,
2,2'-azobis(4-methoxy-2,4-dimethylvaleronitrile),
2,2'-azobis(2,4-dimethylvaleronitrile),
2,2'-azobis(2-methylbutyronitrile),
1,1'-azobis(cyclohexane-1-carbonitrile),
2,2'-azobis(2,4,4-trimethylpentane),
dimethyl-2,2'-azobis(2-methylpropionate), benzoyl peroxide, t-butyl hydroperoxide, di-t-butyl hydroperoxide, t-butyl peroxybenzoate, dicumyl peroxide, 1,1-bis(t-butylperoxy)-3,3,5-trimethylcyclohexane, and 1,1-bis(t-butylperoxy)cyclododecane.

«B. Method of producing surface protective sheet»

The surface protective sheet of the present invention can be produced by any appropriate method. The production can be performed in conformity with, as suchproductionmethod, any appropriate method of producing a pressure-sensitive adhesive sheet, such as:

(1) a method involving applying a solution of the pressure-sensitive adhesive in a solvent or a hot-melt liquid thereof to the base material;
(2) a method involving transferring the pressure-sensitive adhesive layer applied and formed in a separator fashion in conformity with the foregoing;
(3) a method involving extruding a material for forming the pressure-sensitive adhesive layer onto the base material to form and apply the layer;
(4) a method involving extruding the base material and the pressure-sensitive adhesive layer in two layers or a plurality of layers;
(5) a method involving laminating a single layer of the pressure-sensitive adhesive layer onto the base material or a method involving laminating two layers of a laminate layer and the pressure-sensitive adhesive layer; or
(6) a method involving laminating two layers, or a plurality of layers, of the pressure-sensitive adhesive layer and a material for forming the base material such as a film or a laminate layer.

Examples of the above-mentioned application method include methods each involving the use of a bar coater, a gravure coater, a spin coater, a roll coater, a knife coater, oranapplicator.

The method involving applying a solution of the pressure-sensitive adhesive in a solvent or a hot-melt liquid thereof to the base material is particularly preferred as the method of producing the surface protective sheet of the present invention in terms of productivity and a cost.

«C. Applications of surface protective sheet»

The surface protective sheet of the present invention satisfactorily adheres even to a coated surface having a rough surface, and not only does not cause an adhesive residue that can be observed with eyes but also does not impair the self-cleaning property of the surface of a coated plate. Accordingly, the surface protective sheet of the present invention can be used in any appropriate application. The surface protective sheet can be preferably used in, for example, an application where the surface of a member such as a metal plate, a coated plate, an aluminum sash, a resin plate, a decorated steel plate, a vinyl chloride-laminated steel plate, or a glass plate, an optical member such as a polarizing sheet or a liquid crystal panel, an electronic member, or the like is protected by attaching the sheet to the surface of any such member during, for example, conveyance, processing, or guarding of the member. The surface protective sheet is particularly useful as a surface protective sheet, whose degree of contamination is requested to be low, for a hydrophilic member obtained by hydrophilizing the surface of a metal plate, a resin plate, a glass plate, or the like with a hydrophilic coating film or a surface treatment, a substrate with an antireflection function formed so as to have a thickness corresponding to a quarter of a wavelength to be prevented from reflecting, a substrate with an antireflection function based on a nano-level uneven structure, or the like. More specifically, the surface protective sheet of the present invention can be suitably used in an application such as the protection of the surface of a hydrophilic coated plate, the protection of the surface of a substrate whose degree of contamination is requested to be low, the protection of a substrate having an antireflection film, or the protection of the surface of a cover glass for a solar cell.

Hereinafter, the present invention is described specifically by way of examples. However, the present invention is by no means limited to these examples. It should be noted that test and evaluation methods in the examples and the like are as described below. In addition, the term "part(s)" means "part(s) by weight."

(Measurement of spin-spin relaxation time T2)

The spin-spin relaxation times T2 of the polymer P were measured with a pulse NMR apparatus (Model JNM-MU25A manufactured by JEOL LTD. DATUM Solution Business Operations). Specifically, the respective spin-spin relaxation times T2 of polymer components having different cross-link densities were obtained by employing a solid-echo method ($90°x-\tau-90°y$) by: performing measurement under the following measurement conditions to obtain free induction decay signals; and subjecting values for the free induction decay signals to a statistical treatment by a linear least square method. A Weibull coefficient in the statistical treatment was set to 2.

<Measurement conditions>

| | |
|---|---|
| Sample: | A sample of the polymer P (about 1 g; a strap shape measuring 1 mm wide by 10 mm long by 100 $\mu$m thick) was recovered from the pressure-sensitive adhesive layer of the resultant protective sheet, and was then loaded into a predetermined sample tube (trade name "1008-up-7" manufactured by Norell, Inc.). |
| RF pulse width: | 2.2 $\mu$s |
| RF pulse interval: | 8.0 $\mu$s |
| Pulse sequence repetition time: | 2.0 s |
| Measurement temperature: | 35°C |

In addition, the content AM of each polymer component in the polymer P was determined by: subjecting a free induction decay (FID) curve obtained by the pulse NMR measurement to linear square method analysis; specifying a range to be calculated from a component corresponding to each relaxation time T2 after the analysis; and subjecting the range to recalculation by a nonlinear least square method.

Further, $\Sigma$T2AM was calculated from the spin-spin relaxation times T2 and the contents AM of the polymer components thus obtained.

(Insoluble content in ethyl acetate)

About 0.1 g of a polymer (after a cross-linking reaction) was recovered and wrapped with a porous tetrafluoroethylene sheet having an average pore diameter of 0.2 $\mu$m (trade name "NTF1122, " manufactured by Nitto Denko Corporation) . After that, the wrapped product was bound with a kite string and the weight of the resultant at that time was measured. The weight was defined as a weight before immersion. It should be noted that the weight before immersion is the total weight of the polymer (recovered in the foregoing), the tetrafluoroethylene sheet, and the kite string. The total weight of the tetrafluoroethylene sheet and the kite string was also measured, and the weight was defined as a tare weight. Next, the product obtained by wrapping the above-mentioned polymer with the tetrafluoroethylene sheet and binding the wrapped product with the kite string (referred to as "sample") was placed in a 50-ml container filled with ethyl acetate, and was then left at rest at 23°C for 7 days.

After that, the sample (after having been treated with ethyl acetate) was taken out of the container and transferred to an aluminum cup. The sample was dried in a dryer at 130˚C for 2 hours so that ethyl acetate was removed. After that, the weight of the remainder was measured, and the weight was defined as a weight after immersion.

A solvent insoluble content was calculated from the following equation.

$$\text{Solvent insoluble content (wt\%)} = (a-b)/(c-b) \times 100 \quad (1)$$

It should be noted that in the equation (1), a represents the weight after immersion, b represents the tare weight, and c represents the weight before immersion.

In addition, upon recovery of the polymer (after the cross-linking reaction), the polymer may be recovered from the pressure-sensitive adhesive surface of the surface protective sheet, or may be recovered from a product obtained by separately applying the same polymer as that provided for the surface protective sheet to a silicone liner or the like and drying the applied polymer.

(Weight-average molecular weight Mw and molecular weight distribution Mw/Mn)

A weight-average molecular weight Mw and a molecular weight distribution Mw/Mn were measured by a gel permeation chromatography method (GPC method) with an HLC-8120 (manufactured by TOSOH CORPORATION) as described below. The measurement was performed by using columns each having an inner diameter of 6.0 mm and a length of 150 mm (TSKgel SuperHZM-H/HZ4000/HZ3000/HZ2000 manufactured by TOSOH CORPORATION), the columns being connected in series, and tetrahydrofuran as an eluent under the conditions of a concentration of 1 g/L, a flow rate of 0.6 ml/min, a temperature of 40˚C, and a sample injection amount of 20 $\mu$l. An RI detector was used as a detector. In addition, a TSK standard polystyrene (manufactured by TOSOH CORPORATION) was used for creating a molecular weight calibration curve.

(Adhesion for coated steel plate having ten-point average surface roughness Rz of 8.0 $\mu$m)

The adhesion of a surface protective sheet was measured in conformity with JIS Z0237 (2000). That is, a surface protective sheet under test was attached to a hydrophilic coated plate (A02W APPEARCLEAN (white) manufactured by JFE Galvanizing & Coating Co., Ltd.) having a ten-point average surface roughness Rz of 8.0 $\mu$m at a linear pressure of 78.7 N/cm, and after a lapse of 30 minutes from the attachment, its adhesion was measured with an Instron tensile tester (AUTOGRAPH manufactured by Shimadzu Corporation) under the conditions of a release angle of 180˚ and a tension speed of 0.3 m/min.

It should be noted that the ten-point average surface roughness Rz of a coated steel plate was measured in the following manner. That is, the surface roughness of the front surface of a hydrophilic coated steel plate was measured with an optical profiler NT9100 (manufactured by Veeco) under the conditions "Measurement Type: VSI (Infinite Scan), Objective: 2.5X, FOV: 1.0X, Modulation Threshold: 0.1%" for n=3. After the measurement, data analysis was performed under the conditions "Terms Removal: Tilt Only (Plane Fit), Window Filtering: None" to determine the ten-point average surface roughness Rz.

(Rain line contamination property)

A hydrophilic coated steel plate ($100 \times 200 \times 0.3$ mm) to which the resultant surface protective sheet had been attached was mounted on an outdoor exposure stage having a south exposure angle of 45˚, and was then subjected to an exposure test at the rooftop of Nitto Denko Corporation in Toyohashi-shi, Aichi Prefecture for one month. After that, the surface protective sheet was released, and then the remainder was subj ected to the same exposure test for an additional one month. After that, rain line contamination property (rain line-like dirt mark) was visually observed at the time of a fine weather.

Evaluation criteria for the rain line contamination property are as described below.

○: No rain line mark is observed or a rain line mark is slightly observed.
✕: A rain line mark remains.

(Production Example 1): Production of base material 1

A mixture obtained by blending 9 parts of titanium oxide (FTR-700 manufactured by Sakai Chemical Industry Co., Ltd.) with respect to 100 parts of a propylene resin (Prime Polypro F-744NPT manufactured by Prime Polymer Co., Ltd.) was formed into a film by a T-die method so that a die temperature was 230°C. Thus, a base material 1 having a thickness of 40 μm was obtained.

(Production Example 2): Production of base material 2

A mixture obtained by blending 3 parts of titanium oxide (FTR-700 manufactured by Sakai Chemical Industry Co., Ltd.) and 0.1 part of a hindered amine-based light stabilizer (CHIMASSORB 2020 manufactured by BASF) with respect to 100 parts of a polyethylene resin (Petrocene 183 manufactured by TOSOH CORPORATION) was formed into a film by an inflation method so that a die temperature was 160°C. Thus, a base material 2 having a thickness of 50 μm was obtained.

(Production Example 3): Production of base material 3

Abase material 3 was obtained in the same manner as in Production Example 2 except that the thickness was changed to 55 μm.

(Production Example 4): Production of base material 4

Abasematerial 4 was obtained in the samemanner as in Production Example 2 except that the thickness was changed to 60 μm.

(Production Example 5): Production of polymer A(1)

A mixed solution of 97 parts of butyl acrylate and 3 parts of acrylic acid, 0.20 part of 2,2'-azobisisobutyronitrile as a polymerization initiator, and 200 parts of ethyl acetate were loaded into a reaction vessel provided with a cooling tube, a nitrogen-introducing tube, a temperature gauge, and a stirring apparatus, and then the mixture was subjected to polymerization at 60°C for 12 hours. Thus, a solution of a polymer A (1) was obtained. ThepolymerA(1) hadaweight-averagemolecularweightMwof 1, 000, 000 and a molecular weight distribution Mw/Mn of 3.9.

(Production Example 6): Production of polymer A(2)

A solution of a polymer A(2) was obtained in the same manner as in Production Example 5 except that a mixed solution of 56 parts of butyl acrylate, 40 parts of ethyl acrylate, and 4 parts of acrylic acid, 0.20 part of benzoyl peroxide as a polymerization initiator, and 200 parts of toluene were used. The polymer A(2) had a weight-average molecular weight Mw of 1,300,000 and a molecular weight distribution Mw/Mn of 8.1.

(Production Example 7): Production of polymer A(3)

A solution of a polymer A(3) was obtained in the same manner as in Production Example 5 except that a mixed solution of 95 parts of butyl acrylate and 5 parts of acrylic acid, 0.40 part of 2,2'-azobisisobutyronitrile as a polymerization initiator, and 300 parts of ethyl acetate were used. The polymer A(3) had a weight-average molecular weight Mw of 600, 000 and a molecular weight distribution Mw/Mn of 4.0.

(Production Example 8): Production of polymer A(4)

A solution of a polymer A(4) was obtained in the same manner as in Production Example 5 except that a mixed solution of 50 parts of 2-ethylhexyl acrylate, 50 parts of ethyl acrylate, 5 parts of butyl methacrylate, and 4 parts of hydroxyethyl acrylate was used. The polymer A(4) had a weight-average molecular weight Mw of 400, 000 and a molecular weight distribution Mw/Mn of 4.0.

(Production Example 9): Production of polymer A(5)

A mixed solution of 95 parts of butyl acrylate and 5 parts of acrylic acid, 0.20 part of benzoyl peroxide as a polymerization initiator, and 300 parts of toluene were loaded into a reaction vessel provided with a cooling tube, a nitrogen-introducing tube, a temperature gauge, and a stirring apparatus, and then the mixture was subjected to polymerization at 60°C until a polymerization ratio reached 90%. When the polymerization ratio reached 90%, the temperature was increased to 90°C, and then the resultant was subjected to polymerization for 2 hours. Thus, a solution of a polymer A(5) was obtained. The polymer A(5) was then found to have a weight-average molecular weight Mw of 490,000 and a molecular weight distribution Mw/Mn of 15.5.

(Example 1)

A mixed solution obtained by adding 1 part of an epoxy-based cross-linking agent (trade name "TETRAD C" manufactured by Mitsubishi Gas Chemical Company, Inc.) to the above-mentioned solution of the polymer A(1) with respect to 100 parts of the solid content of the polymer A(1) was applied to the base material 1 one surface of which had been subjected to a corona treatment on the corona-treated surface so that the thickness after drying was 15 $\mu$m. Thus, a surface protective sheet was produced. In addition, conditions at the time of the drying were 85°C and 5 minutes. The resultant surface protective sheet was attached to a polyethylene film, and then the resultant was left to stand at 40°C for 2 days. Table 1 shows the results of the evaluations of the surface protective sheet (1) thus obtained provided with a pressure-sensitive adhesive layer (1) constructed of a pressure-sensitive adhesive containing a polymer P(1) obtained by cross-linking the polymer A(1) as a main component.

(Example 2)

A surface protective sheet (2) was produced in the same manner as in Example 1 except that the mixed solution was applied so that the thickness after drying was 5 $\mu$m. Table 1 shows the results of the evaluations of the surface protective sheet (2).

(Example 3)

A surface protective sheet (3) provided with a pressure-sensitive adhesive layer (2) constructed of a pressure-sensitive adhesive containing a polymer P(2) obtained by cross-linking the polymer A(1) as a main component was produced in the same manner as in Example 1 except that: the addition amount of the epoxy-based cross-linking agent was changed to 2 parts; and the thickness after drying was changed to 10 $\mu$m. Table 1 shows the results of the evaluations of the surface protective sheet (3).

(Example 4)

A surface protective sheet (4) was produced in the same manner as in Example 3 except that the base material 3 was used instead of the base material 1. Table 1 shows the results of the evaluations of the surface protective sheet (4).

(Example 5)

A surface protective sheet (5) provided with a pressure-sensitive adhesive layer (3) constructed of a pressure-sensitive adhesive containing a polymer P(3) obtained by cross-linking the polymer A(1) as a main component was produced in the same manner as in Example 1 except that: the addition amount of the epoxy-based cross-linking agent was changed to 3 parts; and the base material 3 was used instead of the base material 1. Table 1 shows the results of the evaluations of the surface protective sheet (5).

(Example 6)

A surface protective sheet (6) was produced in the same manner as in Example 5 except that: a product available under the trade name "Lumirror S10" from Toray Industries, Inc. (thickness: 38 $\mu$m) was used as a base material (base material 6) instead of the base material 1; and the thickness after drying was changed to 3 $\mu$m. Table 1 shows the results of the evaluations of the surface protective sheet (6).

(Example 7)

A surface protective sheet (7) provided with a pressure-sensitive adhesive layer (4) constructed of a pressure-sensitive adhesive containing a polymer P(4) obtained by cross-linking the polymer A(1) as a main component was produced in the same manner as in Example 1 except that the addition amount of the epoxy-based cross-linking agent was changed to 4 parts. Table 1 shows the results of the evaluations of the surface protective sheet (7).

(Example 8)

A surface protective sheet (8) provided with a pressure-sensitive adhesive layer (5) constructed of a pressure-sensitive adhesive containing a polymer P(5) obtained by cross-linking the polymer A(1) as a main component was produced in the same manner as in Example 1 except that the addition amount of the epoxy-based cross-linking agent was changed to 5 parts. Table 1 shows the results of the evaluations of the surface protective sheet (8).

(Example 9)

A surface protective sheet (9) provided with a pressure-sensitive adhesive layer (6) constructed of a pressure-sensitive adhesive containing a polymer P(6) obtained by cross-linking the polymer A(2) as a main component was produced in the same manner as in Example 1 except that: a solution of the polymer A(2) was used instead of the solution of the polymer A(1) ; the addition amount of the epoxy-based cross-linking agent was changed to 2 parts; a product available under the trade name "Lumirror S10" from Toray Industries, Inc. (thickness: 25 $\mu$m) was used as a base material (base material 5) instead of the base material 1; and the thickness after drying was changed to 10 $\mu$m. Table 1 shows the results of the evaluations of the surface protective sheet (9) .

(Example 10)

A surface protective sheet (10) provided with a pressure-sensitive adhesive layer (7) constructed of a pressure-sensitive adhesive containing a polymer P(7) obtained by cross-linking the polymer A(3) as a main component was produced in the same manner as in Example 1 except that: a solution of the polymer A(3) was used instead of the solution of the polymer A(1); the addition amount of the epoxy-based cross-linking agent was changed to 2 parts; the base material 5 was used instead of the base material 1; and the thickness after drying was changed to 10 $\mu$m. Table 1 shows the results of the evaluations of the surface protective sheet (10).

(Example 11)

A surface protective sheet (11) provided with a pressure-sensitive adhesive layer (8) constructed of a pressure-sensitive adhesive containing a polymer P(8) obtained by cross-linking the polymer A(4) as a main component was produced in the same manner as in Example 1 except that: a solution of the polymer A(4) was used instead of the solution of the polymer A(1); 2 parts of an isocyanate-based cross-linking agent (trade name "Coronate L" manufactured by Nippon Polyurethane IndustryCo. , Ltd.) were used instead of 1 part of the epoxy-based cross-linking agent; the base material 4 was used instead of the base material 1; and the thickness after drying was changed to 2.5 $\mu$m. Table 1 shows the results of the evaluations of the surface protective sheet (11) .

(Comparative Example 1)

A surface protective sheet (C1) provided with a pressure-sensitive adhesive layer (12) constructed of a pressure-sensitive adhesive containing a polymer P(9) obtained by cross-linking the polymer A(2) as a main component was produced in the same manner as in Example 1 except that: a solution of the polymer A(2) was used instead of the solution of the polymer A(1); the addition amount of the epoxy-based cross-linking agent was changed to 5 parts; the base material 2 was used instead of the base material 1; and the thickness after drying was changed to 8 $\mu$m. Table 1 shows the results of the evaluations of the surface protective sheet (C1).

(Comparative Example 2)

A surface protective sheet (C2) provided with a pressure-sensitive adhesive layer (13) constructed of a pressure-sensitive adhesive containing a polymer P(10) obtained by cross-linking the polymer A(3) as a main component was produced in the same manner as in Example 1 except that: a solution of the polymer A(3) was used instead of the solution of the polymer A(1); the addition amount of the epoxy-based cross-linking agent was changed to 5 parts; the base material 5 was used instead of the base material 1; and the thickness after drying was changed to 10 $\mu$m. Table 1 shows the results of the evaluations of the surface protective sheet (C2).

(Comparative Example 3)

A surface protective sheet (C3) provided with a pressure-sensitive adhesive layer (14) constructed of a pressure-sensitive adhesive containing a polymer P(11) obtained by cross-linking the polymer A(5) as a main component was produced in the same manner as in Example 1 except that: a solution of the polymer A(5) was used instead of the solution of the polymer A(1); the addition amount of the epoxy-based cross-linking agent was changed to 2 parts; the base material 3 was used instead of the base material 1; and the thickness after drying was changed to 5 $\mu$m. Table 1 shows the results of the evaluations of the surface protective sheet (C3).

[Table 1]

**Examples 1–6**

| | Example 1 | Example 2 | Example 3 | Example 4 | Example 5 | Example 6 |
|---|---|---|---|---|---|---|
| Polymer A | | | Polymer A(1) | Polymer A(1) | | |
| Polymer P | Polymer P(1) | Polymer P(1) | Polymer P(2) | Polymer P(2) | Polymer P(3) | Polymer P(3) |
| Kind of cross-linking agent | Epoxy | Epoxy | Epoxy | Epoxy | Epoxy | Epoxy |
| Amount of cross-linking agent (part(s)) | 1 | 3 | 2 | 3 | 3 | 3 |
| Polymer component — Spin-spin relaxation time (μs) [1 / 2 / 3] | 598.8 / 103.5 / — | 598.8 / 103.5 / — | 529.3 / 97.2 / — | 529.3 / 97.2 / — | 487.2 / 98.1 / — | 487.2 / 98.1 / — |
| Polymer component content (%) [1 / 2 / 3] | 83.8 / 16.2 / — | 83.8 / 16.2 / — | 81.9 / 18.1 / — | 81.9 / 18.1 / — | 79.9 / 20.1 / — | 79.9 / 20.1 / — |
| ΣT2AM | 518.6 | 518.6 | 451.1 | 451.1 | 409.0 | 409.0 |
| Insoluble content in ethyl acetate (wt%) | 98.83 | 98.83 | 98.98 | 98.98 | 99.27 | 99.27 |
| Base material | Base material 1 (40 μm PP) | Base material 1 (40 μm PP) | Base material 1 (40 μm PP) | Base material 3 (55 μm PE) | Base material 3 (55 μm PE) | Base material 6 (38 μm PET) |
| Thickness of pressure-sensitive adhesive layer (μm) | 15 | 5 | 10 | 10 | 3 | 15 |
| Adhesion (N/20 mm) | 2.3 | 1.2 | 0.5 | 0.7 | 0.2 | 0.1 |
| Rain line contamination property | ○ | ○ | ○ | ○ | ○ | ○ |

**Examples 7–11**

| | Example 7 | Example 8 | Example 9 | Example 10 | Example 11 |
|---|---|---|---|---|---|
| Polymer A | Polymer A(1) | Polymer A(1) | Polymer A(2) | Polymer A(3) | Polymer A(4) |
| Polymer P | Polymer P(4) | Polymer P(5) | Polymer P(6) | Polymer P(7) | Polymer P(8) |
| Kind of cross-linking agent | Epoxy | Epoxy | Epoxy | Epoxy | Isocyanate |
| Amount of cross-linking agent (part(s)) | 4 | 5 | 2 | 2 | 2 |
| Polymer component — Spin-spin relaxation time (μs) [1 / 2 / 3] | 454.2 / 83.7 / — | 451.4 / 91.6 / — | 387.4 / 143.3 / 43.6 | 402.3 / 261.9 / 65.2 | 469.9 / 385.9 / 80.6 |
| Polymer component content (%) [1 / 2 / 3] | 80.7 / 19.3 / — | 78.3 / 21.7 / — | 72.5 / 10.4 / 17.1 | 71.0 / 3.5 / 25.6 | 63.9 / 5.3 / 30.8 |
| ΣT2AM | 382.7 | 373.3 | 303.2 | 311.5 | 345.5 |
| Insoluble content in ethyl acetate (wt%) | 99.20 | 99.23 | 98.58 | 98.68 | 95 |
| Base material | Base material 2 (40 μm PP) | Base material 1 (40 μm PP) | Base material 5 (25 μm PET) | Base material 5 (25 μm PET) | Base material 4 (60 μm PE) |
| Thickness of pressure-sensitive adhesive layer (μm) | 15 | 15 | 10 | 10 | 2.5 |
| Adhesion (N/20 mm) | 0.2 | 0.2 | 0.5 | 0.4 | 1.9 |
| Rain line contamination property | ○ | ○ | ○ | ○ | ○ |

**Comparative Examples 1–3**

| | Comparative Example 1 | Comparative Example 2 | Comparative Example 3 |
|---|---|---|---|
| Polymer A | Polymer A(2) | Polymer A(3) | Polymer A(5) |
| Polymer P | Polymer P(9) | Polymer P(10) | Polymer P(11) |
| Kind of cross-linking agent | Epoxy | Epoxy | Epoxy |
| Amount of cross-linking agent (part(s)) | 5 | 5 | 5 |
| Polymer component — Spin-spin relaxation time (μs) [1 / 2 / 3] | 256.0 / 50.7 / — | 323.2 / 298.9 / 60.8 | 459.6 / 334.2 / 74.2 |
| Polymer component content (%) [1 / 2 / 3] | 76.1 / 23.9 / — | 48.9 / 11.0 / 40.1 | 58.4 / 6.2 / 35.4 |
| ΣT2AM | 206.9 | 215.3 | 315.4 |
| Insoluble content in ethyl acetate (wt%) | 99.1 | 99.2 | 94.2 |
| Base material | Base material 2 (50 μm PE) | Base material 5 (25 μm PET) | Base material 3 (55 μm PE) |
| Thickness of pressure-sensitive adhesive layer (μm) | 8 | 10 | 5 |
| Adhesion (N/20 mm) | 0.2 | 0.1 | 0.36 |
| Rain line contamination property | × | × | × |

As is apparent from Table 1, the surface protective sheet of the present invention satisfactorily adheres even to a coated surface having a rough surface, and not only does not cause an adhesive residue that can be observed with eyes but also does not impair the self-cleaning property of the surface of a coated plate.

The surface protective sheet of the present invention is used in, for example, an application where the surface of a member such as a metal plate, a coated plate, an aluminum sash, a resin plate, a decorated steel plate, a vinyl chloride-laminated steel plate, or a glass plate, an optical member such as a polarizing sheet or a liquid crystal panel, an electronic member, or the like is protected by attaching the sheet to the surface of any such member during, for example, conveyance, processing, or guarding of the member. The surface protective sheet is particularly useful as a surface protective sheet for a hydrophilic member such as a hydrophilic coated plate, a substrate with an antireflection function formed so as to have a thickness corresponding to a quarter of a wavelength to be prevented from reflecting, a substrate with an antireflection function based on a nano-level uneven structure, or the like.

**Claims**

1. A surface protective sheet, comprising:

   a base material layer; and
   a pressure-sensitive adhesive layer,
   wherein:

      a main component in a pressure-sensitive adhesive for constructing the pressure-sensitive adhesive layer comprises a polymer P obtained by cross-linking a polymer A;
      in pulse NMR measurement of the polymer P at 35°C, a maximum spin-spin relaxation time $T2_{MAX}$ in all spin-spin relaxation times T2 of protons to be measured falls within a range of 300 to 800 $\mu$s; and
      a content of a polymer component corresponding to the maximum spin-spin relaxation time $T2_{MAX}$ in the polymer P is 60% or more.

2. A surface protective sheet according to claim 1, wherein when a content of a polymer component corresponding to each of the spin-spin relaxation times T2 in the polymer P is represented by AM, $\Sigma T2AM$ is 300 $\mu$s or more.

3. A surface protective sheet according to claim 1 or 2, wherein an insoluble content of the polymer P in ethyl acetate is 98 wt% or more.

4. A surface protective sheet according to any one of claims 1 to 3, wherein the polymer A comprises an acrylic polymer obtained by polymerizing a monomer composition containing a (meth)acrylate monomer as a main component.

5. A surface protective sheet according to any one of claims 1 to 4, wherein the polymer A has a weight-average molecular weight Mw of 500,000 to 1,500,000.

6. A surface protective sheet according to any one of claims 1 to 5, wherein the polymer A has a molecular weight distribution Mw/Mn of 8.0 or less.

7. A surface protective sheet according to any one of claims 1 to 6, wherein the pressure-sensitive adhesive layer has an adhesion for a coated steel plate having a ten-point average surface roughness Rz of 8.0 $\mu$m of 0.05 to 2.5 N/ 20 mm.

8. An article, comprising the surface protective sheet according to any one of claims 1 to 7 releasably attached thereto.

9. A method of using a surface protective sheet, comprising releasably attaching the surface protective sheet according to any one of claims 1 to 7 to an adherend to protect the adherend.

FIG. **1**

Europäisches
Patentamt

European
Patent Office

Office européen
des brevets

**PARTIAL EUROPEAN SEARCH REPORT**

under Rule 62a and/or 63 of the European Patent Convention.
This report shall be considered, for the purposes of
subsequent proceedings, as the European search report

Application Number

EP 11 00 9369

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | EP 1 589 084 A1 (NITTO DENKO CORP [JP]) 26 October 2005 (2005-10-26) * paragraphs [0023], [0024], [0029], [0043], [0047] * * paragraph [0053] - paragraph [0057] *<br>----- | 1-9 | INV.<br>C09J7/02 |
| X | EP 1 375 621 A1 (NITTO DENKO CORP [JP]) 2 January 2004 (2004-01-02) * abstract * * paragraph [0011] - paragraph [0014]; claims 1-7,9; examples 1,2 *<br>----- | 1-9 | |
| X | JP 2006 188607 A (NITTO DENKO CORP) 20 July 2006 (2006-07-20) * abstract; example 3 *<br>----- | 1-9 | |
| X,P | EP 2 308 936 A1 (NITTO DENKO CORP [JP]) 13 April 2011 (2011-04-13) * paragraph [0030] - paragraph [0034] * * paragraph [0049] - paragraph [0053]; claims 2,3; example 1; table 1 *<br>----- | 1-9 | TECHNICAL FIELDS SEARCHED (IPC)<br><br>C09J |

## INCOMPLETE SEARCH

The Search Division considers that the present application, or one or more of its claims, does/do not comply with the EPC so that only a partial search (R.62a, 63) has been carried out.

Claims searched completely :

Claims searched incompletely :

Claims not searched :

Reason for the limitation of the search:

see sheet C

| Place of search | Date of completion of the search | Examiner |
|---|---|---|
| Munich | 26 March 2012 | Meier, Stefan |

EPO FORM 1503 03.82 (P04E07)

Europäisches
Patentamt
European
Patent Office
Office européen
des brevets

**INCOMPLETE SEARCH
SHEET C**

Application Number

EP 11 00 9369

Claim(s) searched incompletely:
        1-9

Reason for the limitation of the search:

Present claim 1 encompasses surface protective sheets defined only by
their desired function, contrary to the requirement of clarity in Art. 84
EPC, because the " result-to-be-achieved " type of definition does not
allow the scope of the claim to be ascertained. The fact that any
compound could be screened does not overcome this objection, as the
skilled person would not know beforehand whether it fell within the scope
claimed, except for the compounds disclosed in the Examples and in claim
4. Undue experimentation would be required to screen compounds randomly.
This non-compliance with the substantive provisions is such that a
meaningful search of the whole claimed subject-matter of the claim could
not be carried out (R. 63 EPC).
In particular, independent claim 1 of the present application claims a
surface protective sheet comprising a pressure-sensitive adhesive layer.
However, said adhesive layer is defined in terms not of its chemical
structure or composition, but solely of its desired properties with
respect to external entities ("in pulse NMR measurement of the polymer P
at 35°C, a maximum spin-spin relaxation time T2MAX in all spin-spin
relaxation times T2 of protons to be measured falls within a range of 300
to 800 microseconds"; and "a content of a polymer component corresponding
to the maximum spin-spin relaxation time T2MAX in the polymer P is 60% or
more."), which the skilled person can establish only by means of using
the method set out in the description.
This type of definition of the pressure-sensitive adhesive layer by means
of its parametric properties relating to its interaction with an external
entity, is directed not only to the compounds actually found according to
the measurement method, but also to any adhesive composition not yet
structurally defined on the priority or filing date of the application
and can only be found by means of the method indicated in claim 1 and in
the description. Such a formulation of a claim thus constitutes a "
reach-through" claim, i.e. a claim which is also directed to future
inventions based on the one now being disclosed.
A definition of an adhesive composition/layer solely by its properties
(in this case in a reach-through claim) covers all adhesive
/compositions/layers possessing the parameter ranges according to the
claim. In the absence of any selection rule in the application in suit,
the skilled person, without the possibility of having recourse to his
common general knowledge, must resort to trial-and error experimentation
on arbitrarily selected chemical compositions for the adhesive layer to
establish whether these layers possess the parameters according to the
claim; this represents for the skilled person an invitation to perform a
research programme and thus an undue burden.
Also for this reason, independent claim 1 does not fulfil the
requirements of Art. 83 EPC. The same considerations apply to claims 2, 3
and 5-9 of the present application since they do not add any definition
in terms of a chemical structure or composition. The only claim providing
some sort of structural definition is claim 4 in combination with claim 1
which define the pressure-sensitive adhesive layer as a crosslinked
acrylic polymer obtained by polymerizing a monomer composition containing
a (meth)acrylate monomer as a main component. This is also supported by

Europäisches
Patentamt

European
Patent Office

Office européen
des brevets

**INCOMPLETE SEARCH
SHEET C**

Application Number

EP 11 00 9369

the Examples of the present application.
Consequently, all claims have been searched in the light of  claim 4, and in the light of the Examples of the present application. I.E. The pressure-sensitive adhesive layer is constituted by a crosslinked acrylic polymer obtained by polymerizing a monomer composition containing a (meth)acrylate monomer as a main component. In order to provide a crosslinkable polymer the presence of a functional group-containing monomer (e.g. acrylic acid  and 2-hydroxyethyl acrylate as used in the Examples) and of an epoxy based crosslinking agent appears to be essential from the Examples and the description. This is also in line with the claims 1-8 indicating the subject-matter to be searched which were provided by the Applicant in the reply to the Invitation pursuant to R. 63(1) EPC.
Consequently, the search has been restricted to the subject-matter indicated in said claims.

**ANNEX TO THE EUROPEAN SEARCH REPORT
ON EUROPEAN PATENT APPLICATION NO.**

EP 11 00 9369

This annex lists the patent family members relating to the patent documents cited in the above-mentioned European search report.
The members are as contained in the European Patent Office EDP file on
The European Patent Office is in no way liable for these particulars which are merely given for the purpose of information.

26-03-2012

| Patent document cited in search report | | | Publication date | Patent family member(s) | | | Publication date |
|---|---|---|---|---|---|---|---|
| EP | 1589084 | A1 | 26-10-2005 | AT | 377056 | T | 15-11-2007 |
| | | | | CN | 1841619 | A | 04-10-2006 |
| | | | | EP | 1589084 | A1 | 26-10-2005 |
| | | | | JP | 4447386 | B2 | 07-04-2010 |
| | | | | JP | 2005317487 | A | 10-11-2005 |
| | | | | KR | 20060044836 | A | 16-05-2006 |
| | | | | US | 2005212427 | A1 | 29-09-2005 |
| EP | 1375621 | A1 | 02-01-2004 | CN | 1470587 | A | 28-01-2004 |
| | | | | DE | 60307729 | T2 | 07-12-2006 |
| | | | | EP | 1375621 | A1 | 02-01-2004 |
| | | | | JP | 4485117 | B2 | 16-06-2010 |
| | | | | JP | 2004027070 | A | 29-01-2004 |
| | | | | KR | 20040030226 | A | 09-04-2004 |
| | | | | TW | I308185 | B | 01-04-2009 |
| | | | | US | 2004001949 | A1 | 01-01-2004 |
| | | | | US | 2007215275 | A1 | 20-09-2007 |
| JP | 2006188607 | A | 20-07-2006 | NONE | | | |
| EP | 2308936 | A1 | 13-04-2011 | CN | 102020943 | A | 20-04-2011 |
| | | | | EP | 2308936 | A1 | 13-04-2011 |
| | | | | JP | 2011063737 | A | 31-03-2011 |
| | | | | US | 2011070437 | A1 | 24-03-2011 |

EPO FORM P0459

For more details about this annex : see Official Journal of the European Patent Office, No. 12/82

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2010042580 A
- JP 2007270022 A
- JP 2001106995 A
- JP 2010106231 A